(19) Europäisches Patentamt / European Patent Office / Office européen des brevets

(11) **EP 4 054 294 B1**

(12) **EUROPEAN PATENT SPECIFICATION**

(45) Date of publication and mention
of the grant of the patent:
**19.03.2025 Bulletin 2025/12**

(21) Application number: **20882168.6**

(22) Date of filing: **29.10.2020**

(51) International Patent Classification (IPC):
*H01L 25/075* (2006.01)     *H01L 33/50* (2010.01)
*H05B 47/105* (2020.01)     *F21V 9/32* (2018.01)
*F21Y 115/10* (2016.01)

(52) Cooperative Patent Classification (CPC):
**H01L 25/0753; H05B 45/20; H10H 20/8512;**
**Y02B 20/40**

(86) International application number:
**PCT/JP2020/040676**

(87) International publication number:
**WO 2021/085546 (06.05.2021 Gazette 2021/18)**

(54) **LIGHTING DEVICE AND COLOR TEMPERATURE CONTROL SYSTEM**

LEUCHTE UND FARBTEMPERATURSTEUERUNGSSYSTEM

APPAREIL D'ÉCLAIRAGE ET SYSTÈME DE COMMANDE DE TEMPÉRATION DE COULEUR

(84) Designated Contracting States:
**AL AT BE BG CH CY CZ DE DK EE ES FI FR GB**
**GR HR HU IE IS IT LI LT LU LV MC MK MT NL NO**
**PL PT RO RS SE SI SK SM TR**

(30) Priority: **30.10.2019   JP 2019197339**
**07.05.2020   JP 2020081805**

(43) Date of publication of application:
**07.09.2022   Bulletin 2022/36**

(73) Proprietor: **NICHIA CORPORATION**
**Anan-shi,**
**Tokushima 774-8601 (JP)**

(72) Inventors:
• **EGUCHI, Junichi**
**Anan-shi, Tokushima 774-8601 (JP)**
• **ASAI, Kenji**
**Anan-shi, Tokushima 774-8601 (JP)**

(74) Representative: **Winter, Brandl - Partnerschaft**
**mbB**
**Alois-Steinecker-Straße 22**
**85354 Freising (DE)**

(56) References cited:
WO-A1-2019/139636     WO-A1-2019/140306
JP-A- 2018 511 386     US-A1- 2017 348 506
US-A1- 2018 077 767     US-A1- 2018 368 218

# EP 4 054 294 B1

**Description**

Technical Field

The present invention relates to a lighting device and a color temperature control system.

Background Art

Lighting is an indispensable element in buildings such as offices, factories, commercial facilities, and houses. Various places of activity of people, such as work, shopping, and gathering, are lit up by lighting.

Conventionally, for such indoor lighting, good luminous efficiency and high color rendering properties are important parameters for evaluating the performance of the lighting. JP 2018- 129 492 A discloses a light emitting device having a high color rendering property with an average color rendering index of 90 or more.

In recent years, in order to set up a human working environment, there is also a tendency to attach importance to consideration of influence on a human body. For example, in the certification system called WELL Standard (Well Building Standard) defined by IWBI (International WELL Building Institute), buildings such as offices are evaluated based on multiple items such as air, water, food, light, and comfort, and certification is given by satisfying the criteria.

For example, with respect to the features for light in the WELL Standard, consideration for the visual environment, consideration for the circadian, and consideration for the glare of electric light and solar light are regarded as essential evaluation items, and the color rendering property is not essential but is an additional item. In such a manner, lighting for lighting up an indoor space where a person works is expected to take into consideration the influence on a human body, but not limited to have good color rendering property.

WO 2019 / 140 306 A1 discloses two-channel tunable lighting systems with controllable equivalent melanopic lux and correlated color temperature outputs. According to the WO 2019 / 140 306 A1, the lighting systems are suitable for generating white light; the lighting systems can have a first lighting channel configured to produce a first white light having a first color point and a first spectral power distribution, a second lighting channel configured to produce a second white light having a second color point and a second spectral power distribution, and a control system configured to independently change the intensity of each of the first lighting channel and the second lighting channel; the first lighting channels can have LEDs having an emission with a first peak wavelength of between about 440 nm and about 510 nm; and the second lighting channels can have LEDs having an emission with a second peak wavelength of between about 380 nm and about 420 nm.

WO 2019 / 139 636 A1 discloses multi-channel systems for providing tunable light with high color rendering and biological effects, wherein the systems for generating tunable white light include a plurality of LED strings that generate light with color points that fall in red, blue, and cyan color ranges, with each LED string being driven with a separately controllable drive current in order to tune the generated light output.

US 2018 / 0 368 218 A1 relates to the field of solid-state lighting, and, in particular, to devices for use in, and methods for, providing tunable white light with high color rendering performance, and WO 2016 / 146 688 A1 relates to a lighting device for providing white light, and, in particular, to the use of such a lighting device to support the human circadian rhythm.

Summary of Invention

Technical Problem

An object is to provide a lighting in consideration of influence on a human body.

Solution to Problem

The object is solved by a lighting device according to independent claim 1.
Advantageous further developments are indicated in the dependent claims.

Advantageous Effects of Invention

According to the present invention, a lighting in consideration of influence on a human body can be provided, compared to conventional lightings.

Brief Description of Drawings

[Figure 1] Figure 1 is a graph showing curves of a circadian response and a visual sensitivity response.

[Figure 2] Figure 2 is a perspective view of the lighting device according to an embodiment of the present disclosure as seen from the light emitting surface side.

[Figure 3] Figure 3 is a perspective view of the lighting device according to the embodiment as seen from the installation surface side.

[Figure 4] Figure 4 is a plan view for illustrating a light emitting surface of the lighting device according to the embodiment.

[Figure 5] Figure 5 is a schematic constitution diagram of a light emitting device included in the lighting device according to the embodiment.

[Figure 6] Figure 6 shows examples of light emission spectra of first light emitting devices used in the lighting device according to the embodiment.

[Figure 7] Figure 7 shows examples of light emission spectra of second light emitting devices used in the lighting device according to the embodiment.

[Figure 8] Figure 8 shows examples of light emission spectra of third light emitting devices used in the lighting device according to the embodiment.

[Figure 9] Figure 9 is a chromaticity diagram of the CIE1931 color system showing chromaticity coordinates of first to third light emitting devices constituting an example of the lighting device according to the embodiment.

[Figure 10] Figure 10 is a chromaticity diagram of the CIE1931 color system showing chromaticity coordinates of first to third light emitting devices constituting an example of the lighting device according to the embodiment.

[Figure 11] Figure 11 is a chromaticity diagram of the CIE1931 color system showing chromaticity coordinates of first to third light emitting devices constituting an example of the lighting device according to the embodiment.

[Figure 12] Figure 12 is a chromaticity diagram of the CIE1931 color system showing chromaticity coordinates of first to third light emitting devices constituting an example of the lighting device according to the embodiment.

[Figure 13] Figure 13 is a chromaticity diagram of the CIE1931 color system showing chromaticity coordinates of first to third light emitting devices constituting an example of the lighting device according to the embodiment.

[Figure 14] Figure 14 is a graph comparing a relative melanopic ratio of the lighting devices of Examples 1 to 5 according to the embodiment and a relative melanopic ratio of a comparative lighting device.

[Figure 15] Figure 15 is a constitution diagram illustrating an example of the color temperature control system according to the embodiment.

[Figure 16A] Figure 16A is a schematic constitution diagram showing another example of the light emitting device according to the embodiment.

[Figure 16B] Figure 16B is a schematic constitution diagram showing another example of the light emitting device according to the embodiment.

[Figure 16C] Figure 16C is a schematic constitution diagram showing another example of the light emitting device according to the embodiment.

Description of Embodiments

First, the effect of lighting on a human body will be described. As an example of the WELL Standard described in the background, a design for lighting in consideration of circadian is required. Here, considering circadian means considering circadian rhythm.

The circadian rhythm of human beings is longer than one day and is approximately 25 hours, and if it is not adjusted to one day, that is, a 24 hours cycle, the rhythm cycle deviates from one day. Thus, light plays an important role as a synchronization factor for adjusting to 24 hours. The human biological clock is adjusted to 24 hours by being exposed to the sunlight, which naturally causes people to live in the rhythm of one day, such as waking up in the morning and going to sleep at night.

That is, in order to live in the rhythm of 24 hours, the human body has a synchronization function utilizing light. Specifically, there is a very small area called the suprachiasmatic nucleus in the hypothalamus of the brain. The suprachiasmatic nucleus plays the role of the biological clock that controls circadian rhythm. As a cell for giving a light signal to the suprachiasmatic nucleus, there is an intrinsically photosensitive Retinal Ganglion Cell (hereinafter, referred to as "ipRGC") on the retina.

The ipRGC contains a photoreceptor protein called melanopsin, and it has been clarified that melanopsin is involved in the photic entrainment of the circadian rhythm. Melanopsin has light absorption characteristics according to the wavelength of light, and the peak is in the vicinity of 480 to 490 nm.

Melanopsin is also involved in secretion or suppression of melatonin which is a sleep promoting hormone, and it is considered that, for example, the secretion of melatonin is suppressed by increasing the amount of stimulation to the ipRGC. Normally, the peak of melatonin secretion in the body comes at night, and the secretion of melatonin promotes sleep. Thus, the secretion of melatonin is suppressed during the day.

In the WELL Standard, an Equivalent Melanopic Lux (hereinafter, referred to as "EML") is introduced in order to evaluate whether or not the design for lighting is in consideration of circadian. The EML is calculated by the following formula (1).

$$EML = Illuminance \times Meranopic\ Ratio \qquad (1)$$

The melanopic ratio (hereinafter, referred to as "MR") in the formula (1) is calculated by the following formula (2).

$$Meranopic\ Ratio = \frac{\sum_{730}^{380} Light \times Circadian}{\sum_{730}^{380} Light \times Visual} \times 1.218 \qquad (2)$$

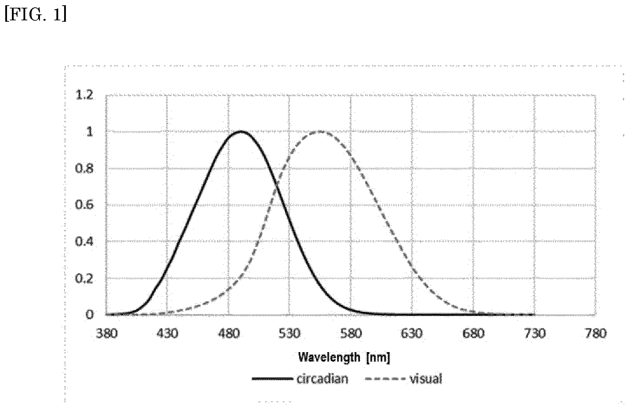

In the formula (2), the "Light" represents a spectral distribution of light from an lighting device, the "Circadian" represents a circadian response based on spectral sensitivity characteristics of the melanopsin having a peak in the vicinity of 480 nm to 490 nm, and the "Visual" represents a visual sensitivity response. FIG. 1 is a graph showing curves of a circadian response and a visual sensitivity response.

As seen from the formula (1), there are two possible ways of increasing the EML value: increasing the illuminance or increasing the MR. Further, it can be seen that the circadian rhythm characteristic is more dependent on the MR than the illuminance. Therefore, it is preferable to consider the MR value in consideration of the circadian rhythm. Further, based on the circadian response, the light emission intensity in a wavelength range of approximately 470 nm to 490 nm is considered to be a wavelength range particularly contributing to the secretion control of melatonin.

Embodiments for carrying out the present invention will be hereunder described with reference to the drawings. The embodiments described below are intended to embody the technical idea of the present invention and are not intended to limit the scope of the present invention as defined by the claims. Further, in the following description, the same name or symbol represents the same or equivalent member, and detailed description thereof will be omitted as appropriate. The sizes and positional relationships of members shown in each drawing may be exaggerated for clarity of explanation. The relationships between color names and chromaticity coordinates, and the relationships between wavelength ranges of light and color names of monochromic light are in accordance with Japanese Industrial Standard (JIS) Z8110.

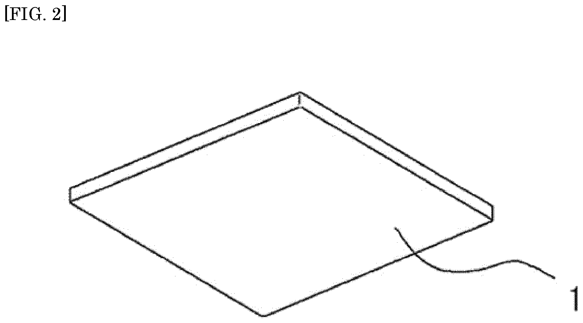

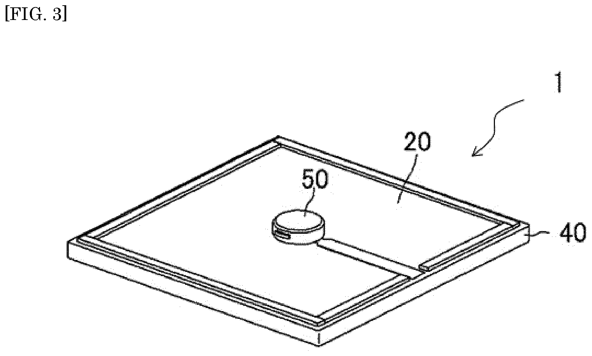

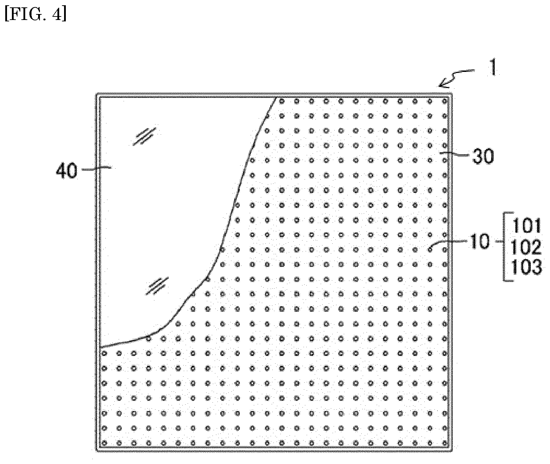

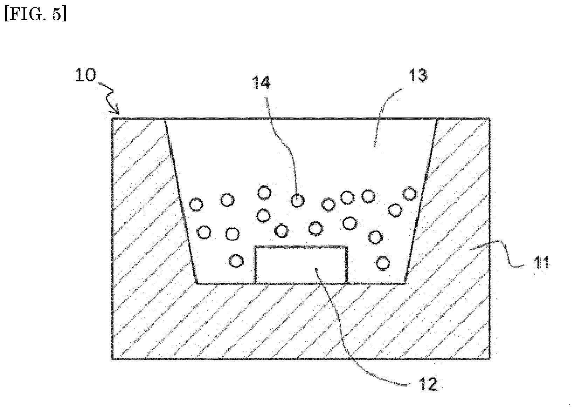

The lighting device according to **an** embodiment will be described. FIG. 2 is a perspective view of a lighting device 1 as seen from the light emitting surface side. FIG. 3 is a perspective view of the lighting device 1 as seen from the installation surface side (the side opposite to the light emitting surface side). FIG. 4 is a diagram showing the light emitting surface of the lighting device 1, and shows an internal structure except for a part of a cover 40 of the lighting device 1. FIG. 5 is a cross-sectional view showing an outline of a light emitting device 10 included in the lighting device 1.

The lighting device 1 includes at least three light emitting devices 10 that respectively emit lights with different chromaticity coordinates based on the chromaticity diagram of the CIE1931 color system (hereinafter, simply referred to as "chromaticity diagram"). The three light emitting devices 10 are respectively referred to as a first light emitting device 101, a second light emitting device 102, and a third light emitting device 103 to distinguish them.

By using the three light emitting devices 10 installed in the lighting device 1, the irradiated light can be changed in a predetermined color temperature range. The color temperature range controlled using the lighting device 1 is described as a range from the first temperature to the second temperature. The color temperature range needs to be within the maximum color temperature range at which the lighting device 1 can change the color temperature, but does not need to be the maximum range. However, the light emitted from the lighting device 1 is controlled within a color temperature range of 2,000 K or more.

For example, the first temperature may be set to 2,700 K and the second temperature may be set to 6,500 K (i.e., the color temperature can be changed within a color temperature range of 3,800 K). Alternatively, for example, the first temperature may be set to 3,000 K and the second temperature may be set to 5,000 K (the color temperature can be changed within a color temperature range of 2,000 K).

Three light emitting devices 10 each having different chromaticity coordinates with appropriate characteristics are combined in the lighting device 1, so that the light along the black body radiation locus can be emitted with consideration of the circadian rhythm when controlling the color temperature.

In the chromaticity diagram of the CIE1931 color system, the chromaticity coordinates of the light emitted from the first light emitting device 101 are defined as first chromaticity coordinates, the chromaticity coordinates of the light emitted from the second light emitting device 102 are defined as second chromaticity coordinates, and the chromaticity coordinates of the light emitted from the third light emitting device 103 are defined as third chromaticity coordinates.

In order to control the light from the first temperature to the second temperature along the black body radiation locus, light emitted from the lighting device 1 includes light in a range from at least the first temperature to the second temperature, that is, light on the black body radiation locus in which the color deviation duv from the black body radiation locus measured according to JIS Z8725 is 0.00, is within a triangular area connecting three points of the first chromaticity coordinates, the second chromaticity coordinates, and the third chromaticity coordinates.

The three light emitting devices 10 satisfy the following conditions.

As for the first light emitting device 101, the values of x and y in the first chromaticity coordinates are equal to or less than the values of x and y at the second temperature on the black body radiation locus, respectively, in the chromaticity diagram of the CIE1931 color system. Preferably, the value of x in the first chromaticity coordinates is smaller than the value of x at the second temperature on the black body radiation locus, and the difference between the value of x in the first chromaticity coordinates and the value of x at the second temperature on the black body radiation locus is 0.1 or more. In the chromaticity diagram of the CIE1931 color system, the value of x in the first chromaticity coordinates is in a range of 0.1 or more and 0.2 or less. In the chromaticity diagram of the CIE1931 color system, the value of y in the first chromaticity coordinates is in a range of 0.2 or more and 0.3 or less. A light emitting device having a high MR value is employed as the first light emitting device 101.

As for the second light emitting device 102, the value of x in the second chromaticity coordinates is equal to or more than the value of x at the first temperature on the black body radiation locus in the chromaticity diagram of the CIE1931 color system In the chromaticity diagram of the CIE1931 color system, the value of x in the second chromaticity coordinates is in a range of 0.45 or more and 0.6 or less. In the chromaticity diagram, of the CIE1931 color system the value of y in the second chromaticity coordinates is equal to or less than the value of y at the first temperature on the black body radiation locus. In the chromaticity diagram of the CIE1931 color system, the value of y in the second chromaticity coordinates is in a range of 0.3 or more and 0.5 or less. A light emitting device having a low MR value is employed as the second light emitting device 102.

As for the third light emitting device 103, the third chromaticity coordinates are located in the +y direction with respect to the straight line passing through the first temperature and the second temperature on the black body radiation locus in the chromaticity diagram of the CIE1931 color system. That is, when the value of x in the third chromaticity coordinates is a first value, the value of y in the third chromaticity coordinates is larger than the value of y obtained by substituting the first value for the value of x in the function representing the straight line. In this example, in the case in which the value of x in the third chromaticity coordinates is the first value, the value of y in the third chromaticity coordinates is referred to as a second value. In the third chromaticity coordinates, the value of x is equal to or less than the value of x at the second temperature on the black body radiation locus, and the value of y is equal to or more than the value of y at the second temperature on the black body radiation locus.

As for the third light emitting device 103, the value of x in the third chromaticity coordinates is in a range of 0.1 or more and 0.6 or less in the chromaticity diagram of the CIE1931 color system. The value of x in the third chromaticity coordinates can be in a range of 0.4 or more and 0.5 or less, in the chromaticity diagram of the CIE1931 color system. The value of x in the third chromaticity coordinates can be in a range of 0.3 or more and 0.4 or less, in the chromaticity diagram of the CIE1931 color system. The value of y in the third chromaticity coordinates is in a range of 0.3 or more and 0.6 or less in the chromaticity diagram. A light emitting device having an MR value lower than that of the first light emitting device 101 and higher than that of the second light emitting device 102, is employed as the third light emitting device 103.

The high MR value described in the first light emitting device 101 means that the MR value is a value close to 2.00 or a value larger than 2.00. The MR value of the first light emitting device 101 is preferably 2.00 or more, more preferably 2.50 or more, and even more preferably 2.80 or more. The higher the MR value, the more suppressed the secretion of melatonin. The MR value of the first light emitting device 101 is 3.00 or less. However, the upper limit value can exceed 3.00.

The low MR value described in the second light emitting device 102 means that the MR value is a value close to 0.40 or a value smaller than 0.40. The MR value of the second light emitting device 102 is preferably 0.40 or less, more preferably 0.30 or less, and even more preferably 0.25 or less. The lower the MR value, the more stimulated the secretion of melatonin. The MR value of the second light emitting device 102 is 0.0 or more.

In the chromaticity diagram of the CIE1931 color system, in the case in which the value of x in the third chromaticity coordinates is 0.1 or more smaller than the middle of the value of x in the first chromaticity coordinates and the value of x in the second chromaticity coordinates, a light emitting device having an MR value of 1.0 or more can be employed as the third light emitting device 103. On the other hand, in the case in which the value of x in the third chromaticity coordinates is larger than the middle value and a difference between the value of x in the third chromaticity coordinates and the middle value is 0.1 or more, a light emitting device having an MR value of 0.5 or less can be employed. Further, in the case of being less than $\pm 0.1$ from the middle value, a light emitting device having an MR value in a range of 0.5 or more and 1.0 or less can be employed. The MR value of the third light emitting device 103 is preferably 2.00 or more.

The lighting device 1 emitting light as a whole has a configuration in which a plurality of these three light emitting devices 10 are disposed, or four or more light emitting devices 10 including these three light emitting devices 10 and other light emitting device(s).

The lighting device 1 includes a base plate 20, a substrate 30, at least one light emitting device 10, a cover 40, and an installation member 50. The lighting device 1 is connected to a controller that adjusts the light emitted from the lighting device 1. The controller can be incorporated in the lighting device 1.

The controller is equipped with a driver program for adjusting the light emitted from the lighting device 1. The program is installed in a memory of the controller, such as a ROM or a RAM, and is expanded by a processor such as a CPU to execute processing.

In the lighting device 1, the substrate 30 is attached to the base plate 20. A plurality of light emitting devices 10 are mounted on the substrate 30. The plurality of light emitting devices 10 are electrically connected through wiring, and electric power is supplied from an external power source to control light emission from the light emitting devices 10.

The cover 40 is attached to the base plate 20 so as to cover the plurality of light emitting devices 10 arranged on the substrate 30. The installation member 50 is provided on the surface (i.e., installation surface) of the base plate 20 opposite to the surface on which the light emitting devices 10 are arranged. The lighting device 1 is installed on a support member by the installation member 50. The support member is, for example, a ceiling, a wall, or a stand. FIG. 3 shows an example in which the installation member 50 is installed on the ceiling.

In the lighting device 1, the first light emitting device 101, the second light emitting device 102, and the third light emitting device 103 are successively arranged as the light emitting devices 10. In the example of FIG. 4, the plurality of light emitting devices 10 are arranged in a matrix, and the first light emitting device 101, the second light emitting device 102, and the third light emitting device 103 are successively arranged by one column (or one row) each. These light emitting devices can be alternately arranged in units that are not in row or column units. For example, these light emitting devices can be alternately arranged in units of one light emitting device or in units of a plurality of light emitting devices. The first light emitting device 101, the second light emitting device 102, and the third light emitting device 103 each include a light emitting element and a fluorescent material.

The light emitting device 10 includes a molded body 11, at least one light emitting element 12, and a wavelength conversion member 13. As the light emitting element 12, a nitride semiconductor having a light emission peak in a range of 410 nm or more and 490 nm or less can be employed. As the wavelength conversion member 13, a fluorescent material 14 that is excited by light emitted from the light emitting element 12 and emits light having a different wavelength can be employed. The molded body 11 is a housing in which the light emitting element 12 and the wavelength conversion member 13 are housed. In this specification, interpretation of the "fluorescent material" includes a "fluorescent phosphor".

The first light emitting device 101 and the second light emitting device 102 each contain a fluorescent material having a mutually different composition as a main fluorescent material. The main fluorescent material means the fluorescent material contained the most in the wavelength conversion member 13 of the light emitting device 10. By employing a light emitting device including a different main fluorescent material, the difference between the MR value at a high color temperature and the MR value at a low color temperature can be made larger than in a case of employing a light emitting device having the same main fluorescent material.

The light emitting element 12 is not limited to a nitride semiconductor. The light emitting element 12 can be a light emitting element having a light emission peak outside the above range. As the light emitting element, an LED, an organic electroluminescent display (organic EL), a laser diode, or the like can be used. The molded body 11 can not be provided.

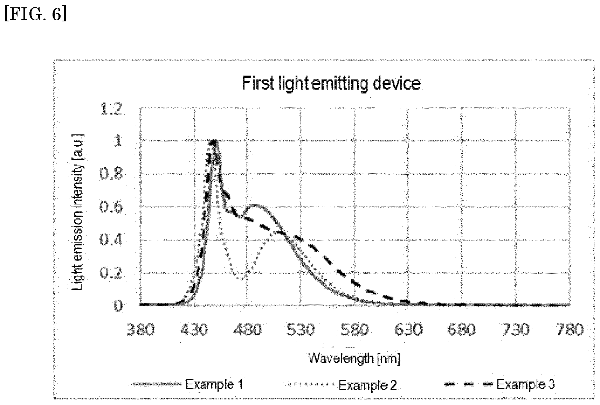

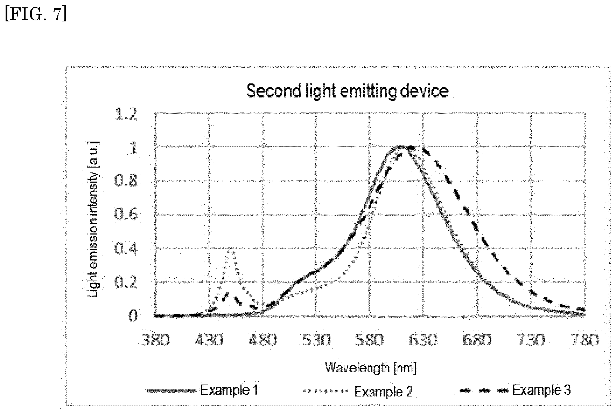

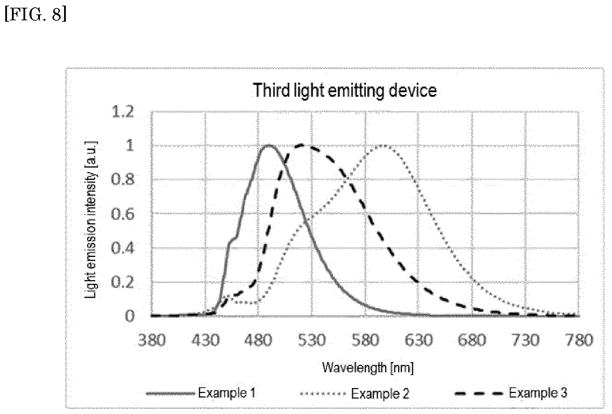

Hereinafter, specific examples of light emitting devices to be employed as the first light emitting device 101, the second light emitting device 102, and the third light emitting device 103 will be described. FIG. 6 shows a light emission spectrum of each Example of the first light emitting device 101. FIG. 7 shows a light emission spectrum of each Example of the second light emitting device 102. FIG. 8 shows a light emission spectrum of each Example of the third light emitting device 103.

<First Light Emitting Device 101, Example 1>

As the first light emitting device 101, for example, a light emitting device including: a light emitting element 12, which is a nitride semiconductor, having a light emission peak in a range of 410 nm or more and 470 nm or less, and preferably having a light emission peak in a range of 420 nm or more and 460 nm or less; and a wavelength conversion member 13 containing an alkaline earth metal aluminate fluorescent material having a composition represented by a formula of $Sr_4Al_{14}O_{25}$:Eu as a main fluorescent material and having a light emission peak at 495 nm, can be used. In the first light emitting device 101, the x value of the first chromaticity coordinates is 0.149 and the y value thereof is 0.223 in the chromaticity diagram of the CIE1931 color system. The MR value is 2.85. The luminous efficiency is 122 lm/W.

<First Light Emitting Device 101, Example 2>

As the first light emitting device 101, for example, a light emitting device including: a light emitting element 12, which is a nitride semiconductor, having a light emission peak in a range of 410 nm or more and 490 nm or less; and a wavelength conversion member 13 containing a chlorosilicate fluorescent material having a composition represented by a formula of $Ca_8Mg(SiO_4)_4Cl_2$:Eu as a main fluorescent material and having a light emission peak at 510 nm, can be used. In the first light emitting device 101, the x value of the first chromaticity coordinates is 0.167 and the y value thereof is 0.246 in the chromaticity diagram of the CIE1931 color system. The MR value is 2.07. The luminous efficiency is 145 lm/W.

<First Light Emitting Device 101, Example 3>

As the first light emitting device 101, for example, a light emitting device including: a light emitting element 12, which is a nitride semiconductor, having a light emission peak in a range of 410 nm or more and 470 nm or less; and a wavelength conversion member 13 containing a rare earth aluminate fluorescent material having a composition represented by a formula of $Lu_3(Al,Ga)_5O_{12}$:Ce as a main fluorescent material and having a light emission peak at 496 nm, can be used. In the first light emitting device 101, the x value of the first chromaticity coordinates is 0.191 and the y value thereof is 0.265 in the chromaticity diagram of the CIE1931 color system. The MR value is 1.94. The luminous efficiency is 148 lm/W.

<Second Light Emitting Device 102, Example 1>

As the second light emitting device 102, for example, a light emitting device including: a light emitting element 12, which is a nitride semiconductor, having a light emission peak in a range of 410 nm or more and 490 nm or less; and a wavelength conversion member 13 containing a rare earth aluminate fluorescent material having a composition represented by a formula of $Y_3Al_5O_{12}$:Ce, a rare earth aluminate fluorescent material having a composition represented by a formula of $Lu_3Al_6O_{12}$:Ce, and a silicon nitride fluorescent material having a composition represented by a formula of $(Sr,Ca)AlSiN_3$:Eu, as a main fluorescent material, can be used. In the second light emitting device 102, the x value of the second chromaticity coordinates is 0.539, the y value thereof is 0.443, the correlated color temperature is 2,000 K, and the color deviation duv is +0.01, in the chromaticity diagram of the CIE1931 color system. The MR value is 0.23. The luminous efficiency is 168 lm/W.

<Second Light Emitting Device 102, Example 2>

As the second light emitting device 102, for example, a light emitting device including: a light emitting element 12, which is a nitride semiconductor, having a light emission peak in a range of 410 nm or more and 490 nm or less; and a wavelength conversion member 13 containing a rare earth aluminate fluorescent material having a composition represented by a formula of $Y_3Al_5O_{12}$:Ce, a rare earth aluminate fluorescent material having a composition represented by a formula of $Lu_3Al_6O_{12}$:Ce, and a silicon nitride fluorescent material having a composition represented by a formula of $(Sr,Ca)AlSiN_3$:Eu, as a main fluorescent material, can be used. In the second light emitting device 102, the x value of the second chromaticity coordinates is 0.505, the y value thereof is 0.359, the correlated color temperature is 2,000 K, and the color deviation duv is -0.02, in the chromaticity diagram of the CIE1931 color system. The MR value is 0.35. The luminous efficiency is 144 lm/W.

<Second Light Emitting Device 102, Example 3>

As the second light emitting device 102, for example, a light emitting device including: a light emitting element 12, which is a nitride semiconductor, having a light emission peak in a range of 410 nm or more and 490 nm or less; and a wavelength conversion member 13 containing a rare earth aluminate fluorescent material having a composition represented by a formula of $Y_3Al_5O_{12}$:Ce, a rare earth aluminate fluorescent material having a composition represented by a formula of $Lu_3Al_6O_{12}$:Ce, and a silicon nitride fluorescent material having a composition represented by a formula of (Sr,Ca)AlSiN$_3$:Eu, as a main fluorescent material, can be used. In the second light emitting device 102, the x value of the second chromaticity coordinates is 0.524, the y value thereof is 0.416, the correlated color temperature is 2,000 K, and the color deviation duv is 0.00, in the chromaticity diagram of the CIE1931 color system. The MR value is 0.28. The luminous efficiency is 131 lm/W.

<Third Light Emitting Device 103, Example 1>

As the third light emitting device 103, for example, a light emitting device including: a light emitting element 12, which is a nitride semiconductor, having a light emission peak in a range of 410 nm or more and 470 nm or less, and preferably having a light emission peak in a range of 420 nm or more and 460 nm or less; and a wavelength conversion member 13 containing an alkaline earth metal aluminate fluorescent material having a composition represented by a formula of $Sr_4Al_{14}O_{25}$:Eu as a main fluorescent material and having a light emission peak at approximately 495 nm, can be used. In the third light emitting device 103, the x value of the third chromaticity coordinates is 0.145 and the y value thereof is 0.354 in the chromaticity diagram of the CIE1931 color system. The MR value is 2.32. The luminous efficiency is 151 lm/W.

<Third Light Emitting Device 103, Example 2>

As the third light emitting device 103, for example, a light emitting device including: a light emitting element 12, which is a nitride semiconductor, having a light emission peak in a range of 410 nm or more and 490 nm or less; and a wavelength conversion member 13 containing a rare earth aluminate fluorescent material having a composition represented by a formula of $Y_3Al_5O_{12}$:Ce, a rare earth aluminate fluorescent material having a composition represented by a formula of $Lu_3Al_6O_{12}$:Ce, and a silicon nitride fluorescent material having a composition represented by a formula of (Sr,Ca)AlSiN$_8$:Eu, as a main fluorescent material, can be used. In the third light emitting device 103, the x value of the third chromaticity coordinates is 0.467, the y value thereof is 0.471, the correlated color temperature is 3,000 K, and the color deviation duv is +0.02, in the chromaticity diagram of the CIE1931 color system. The MR value is 0.38. The luminous efficiency is 204 lm/W.

<Third Light Emitting Device 103, Example 3>

As the third light emitting device 103, for example, a light emitting device including: a light emitting element 12, which is a nitride semiconductor, having a light emission peak in a range of 410 nm or more and 490 nm or less; and a wavelength conversion member 13 containing a rare earth aluminate fluorescent material having a composition represented by a formula of $Y_3(Al,Ga)_5O_{12}$:Ce as a main fluorescent material and having a light emission peak at approximately 496 nm, can be used. In the third light emitting device 103, the x value of the third chromaticity coordinates is 0.331 and the y value thereof is 0.548 in the chromaticity diagram of the CIE1931 color system. The MR value is 0.76. The luminous efficiency is 242 lm/W.

Next, the lighting device 1 constituted by including the above-mentioned first light emitting device 101, the second light emitting device 102, and the third light emitting device 103, will be exemplified. As a comparison object with the lighting device 1, the lighting device described below (hereinafter, referred to as "comparative lighting device") is employed. The comparative lighting device is selected from the viewpoint of good luminous efficiency and high color rendering properties conventionally expected for lighting.

<Comparative Lighting device>

The comparative lighting device is constituted of two light emitting devices respectively having correlated color temperatures of 2,700 K and 6,500 K, and having a color deviation of 0.00. Each of the light emitting devices includes: a light emitting element 12, which is a nitride semiconductor, having a light emission peak in a range of 410 nm or more and 490 nm or less; and a wavelength conversion member 13 containing a rare earth aluminate fluorescent material having a composition represented by a formula of $Y_3Al_5O_{12}$:Ce, a rare earth aluminate fluorescent material having a composition represented by a formula of $Lu_3Al_6O_{12}$:Ce, and a silicon nitride fluorescent material having a composition represented by a formula of (Sr,Ca)AlSiN$_3$:Eu. The average color rendering index (hereinafter, referred to as "Ra") is 80 or more, and the luminous efficiency is 180 lm/W to 200 lm/W at the correlated color temperature in a range of 2,700 K to 6,500 K. The details are shown in Table A below.

[Table A]

| Target color temperature Tcp [K] | Result color temperature Tcp [K] | Color deviation duv | Melanopic ratio MR | Luminous efficiency [lm/W] | Average color rendering index Ra |
|---|---|---|---|---|---|
| 2700 | 2762 | 0.001 | 0.44 | 184 | 82 |
| 3000 | 3066 | -0.003 | 0.52 | 189 | 84 |
| 3500 | 3570 | -0.005 | 0.62 | 195 | 85 |
| 4000 | 4066 | -0.005 | 0.70 | 197 | 85 |
| 4500 | 4563 | -0.005 | 0.77 | 198 | 85 |
| 5000 | 5053 | -0.004 | 0.82 | 198 | 85 |
| 5700 | 5738 | -0.001 | 0.89 | 197 | 84 |
| 6500 | 6520 | 0.001 | 0.95 | 195 | 83 |

<Lighting device 1, Example 1>

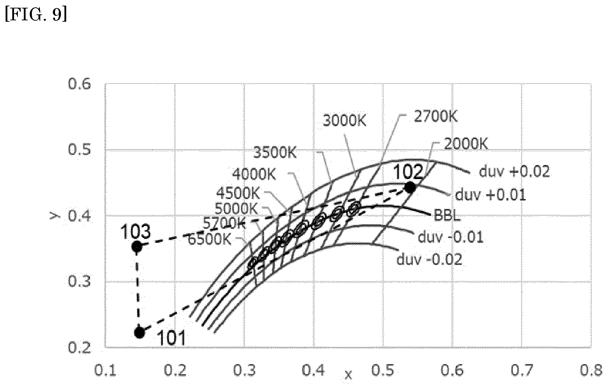

The lighting device 1 of Example 1 is constituted of the first light emitting device 101, the second light emitting device 102, and the third light emitting device 103 of each Example 1. Table 1 shows a result of which the lighting device 1 is evaluated by using the items in the above Table A. The chromaticity diagram of the CIE1931 color system showing a relationship among the first to third chromaticity coordinates, the color temperature changeable range (triangle connecting three points), and the black body radiation locus, in the lighting device 1 of Example 1 is shown in FIG. 9.

[Table 1]

| Target color temperature Tcp [K] | Result color temperature Tcp [K] | Color deviation duv | Melanopic ratio MR | Luminous efficiency [lm/W] | Average color rendering index Ra |
|---|---|---|---|---|---|
| 2700 | 2706 | 0.000 | 0.55 | 167 | 85 |
| 3000 | 3005 | 0.000 | 0.66 | 167 | 86 |
| 3500 | 3511 | 0.000 | 0.81 | 166 | 84 |
| 4000 | 4020 | 0.000 | 0.93 | 164 | 83 |
| 4500 | 4533 | 0.000 | 1.03 | 162 | 82 |
| 5000 | 5037 | 0.000 | 1.11 | 160 | 81 |
| 5700 | 5744 | 0.000 | 1.21 | 157 | 80 |
| 6500 | 6559 | 0.000 | 1.30 | 154 | 80 |

As described above, in the lighting device 1 of Example 1, the MR change amount in the correlated color temperature range of 2,700 K to 6,500 K is 0.75, which is larger than that of the comparative lighting device. Also, the MR change amount in the range of 3,000 to 5,000 K is 0.45, which is larger than that of the comparative lighting device. Further, the MR value at each of the same color temperatures is higher than that of the comparative lighting device. Here, the same target color temperatures are used for comparing the lighting devices. There are differences between the target color temperatures and actual result color temperatures, but they are allowed, and the target color temperature is employed as the color temperature in the present disclosure. The MR value of the lighting device 1 of Example 1 is 1.0 or more when light having a correlated color temperature of 5,000 K on the black body radiation locus (the color deviation duv is 0.000) is emitted. The MR change amount of the lighting device 1 of Example 1 is 0.4 or more when the color temperature of light is changed in a range of correlated color temperatures of 3,000 K to 5,000 K on the black body radiation locus.

The luminous efficiency of the lighting device 1 of Example 1 is slightly inferior to that of the comparative lighting device. The luminous efficiency at each of the color temperatures in the range of 2,700 K to 6,500 K as well as the range of 3,000 K to 5,000 K achieves 160 [lm/W] in each color temperature range, but not 170 [lm/W]. The color rendering property is at substantially the same level as that of the comparative lighting device. The Ra achieves 80 at each color temperature range, but not 85.

<Lighting device 1, Example 2>

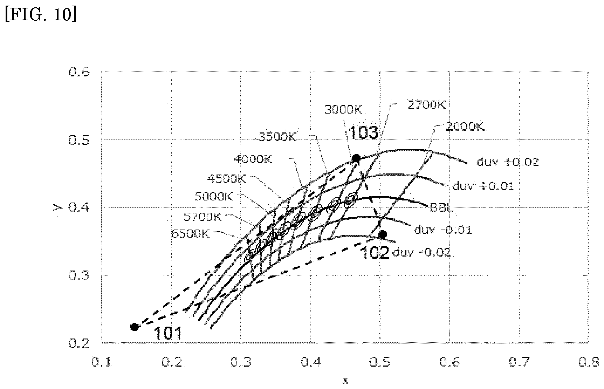

The lighting device 1 of Example 2 is constituted of the first light emitting device 101 of Example 1, and the second light emitting device 102 and the third light emitting device 103 of each Example 2. Table 2 shows a result of which the lighting device 1 is evaluated by using the items in the above Table A. The chromaticity diagram of the CIE1931 color system showing a relationship among the first to third chromaticity coordinates, the color temperature changeable range (triangle connecting three points), and the black body radiation locus, in the lighting device 1 of Example 2 is shown in FIG. 10.

[Table 2]

| Target color temperature Tcp [K] | Result color temperature Tcp [K] | Color deviation duv | Melanopic ratio MR | Luminous efficiency [lm/W] | Average color rendering index Ra |
|---|---|---|---|---|---|
| 2700 | 2696 | 0.000 | 0.46 | 184 | 84 |
| 3000 | 3000 | 0.000 | 0.55 | 185 | 87 |
| 3500 | 3503 | 0.000 | 0.69 | 184 | 89 |
| 4000 | 4009 | 0.000 | 0.81 | 181 | 91 |
| 4500 | 4515 | 0.000 | 0.92 | 177 | 91 |
| 5000 | 5022 | 0.000 | 1.01 | 173 | 90 |
| 5700 | 5725 | 0.000 | 1.12 | 168 | 88 |
| 6500 | 6541 | 0.000 | 1.24 | 163 | 86 |

As described above, in the lighting device 1 of Example 2, the MR change amount in the correlated color temperature range of 2,700 K to 6,500 K is larger than that of the comparative lighting device. Also, the MR change amount in the range of 3,000 K to 5,000 K is larger than that of the comparative lighting device. Further, the MR value at each of the same color temperatures is higher than that of the comparative lighting device. The MR value of the lighting device 1 of Example 2 is 1.0 or more when light having a correlated color temperature of 5,000 K on the black body radiation locus (the color deviation duv is 0.000) is emitted. The MR change amount of the lighting device 1 of Example 2 is 0.4 or more when the color temperature of light is changed in a range of correlated color temperatures of 3,000 K to 5,000 K on the black body radiation locus.

In particular, in the lighting device 1 of Example 2, the MR value at a low color temperature (first color temperature) is not much different from that of the comparative lighting device, and the difference is widened at a high color temperature (second color temperature). It can be said that the lighting device 1 of Example 2 is effective for the life rhythm in which the human body becomes active during the daytime and calms down after the evening.

The luminous efficiency of the lighting device 1 of Example 2 is inferior to that of the comparative lighting device, but is superior to that of the lighting device 1 of Example 1. The luminous efficiency at each of the color temperatures in the range of 2,700 K to 6,500 K as well as the range of 3,000 K to 5,000 K achieves 170 [lm/W] in each color temperature range, but not 180 [lm/W]. The color rendering property of the lighting device 1 of Example 2 is superior to those of the comparative lighting device and the lighting device 1 of Example 1. The Ra achieves 85 or more at each color temperatur range, but not 90. When the color temperature of light is changed in a range of correlated color temperatures of 3,000 K to 5,000 K on the black body radiation locus (the color deviation duv is 0.000), the average color rendering index of the lighting device 1 of Example 2 reaches 85, and the luminous efficiency [lm/W] of the lighting device 1 of Example 2 reaches 170.

<Lighting device 1, Example 3>

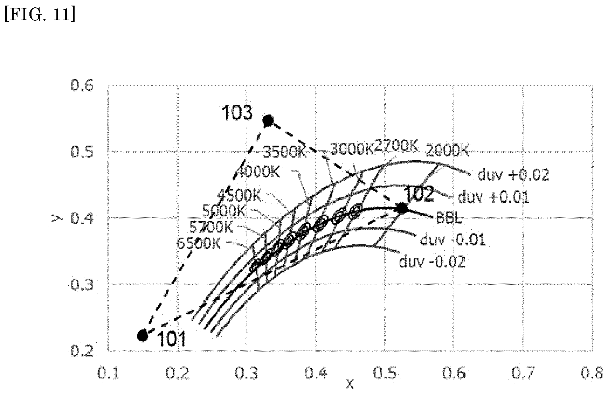

The lighting device 1 of Example 3 is constituted of the first light emitting device 101 of Example 1, and the second light emitting device 102 and the third light emitting device 103 of each Example 3. Table 3 shows a result of which the lighting device 1 is evaluated by using the items in the above Table A. The chromaticity diagram of the CIE1931 color system showing a relationship among the first to third chromaticity coordinates, the color temperature changeable range (triangle connecting three points), and the black body radiation locus, in the lighting device 1 of Example 3 is shown in FIG. 11.

[Table 3]

| Target color temperature Tcp [K] | Result color temperature Tcp [K] | Color deviation duv | Melanopic ratio MR | Luminous efficiency [lm/W] | Average color rendering index Ra |
|---|---|---|---|---|---|
| 2700 | 2688 | 0.000 | 0.51 | 143 | 94 |
| 3000 | 2989 | 0.000 | 0.60 | 146 | 95 |
| 3500 | 3483 | 0.000 | 0.73 | 149 | 93 |
| 4000 | 3986 | 0.000 | 0.85 | 149 | 92 |
| 4500 | 4485 | 0.000 | 0.95 | 148 | 89 |
| 5000 | 4983 | 0.000 | 1.04 | 146 | 87 |
| 5700 | 5684 | 0.000 | 1.15 | 143 | 84 |
| 6500 | 6487 | 0.000 | 1.26 | 140 | 82 |

As described above, in the lighting device 1 of Example 3, the MR change amount in the correlated color temperature range of 2,700 K to 6,500 K is larger than that of the comparative lighting device. Also, the MR change amount in the range of 3,000 K to 5,000 K is larger than that of the comparative lighting device. Further, the MR value at each of the same color temperatures is higher than that of the comparative lighting device. The MR value of the lighting device 1 of Example 3 is 1.0 or more when light having a correlated color temperature of 5,000 K on the black body radiation locus (the color deviation duv is 0.000) is emitted. The MR change amount of the lighting device 1 of Example 3 is 0.4 or more when the color temperature of light is changed in a range of correlated color temperatures of 3,000 K to 5,000 K on the black body radiation locus.

The luminous efficiency of the lighting device 1 of Example 3 is inferior to that of the comparative lighting device. The luminous efficiency at each of the color temperatures in the range of 2,700 K to 6,500 K as well as the range of 3,000 K to 5,000 K achieves 140 [lm/W] in each color temperature range, but not 150 [lm/W]. The color rendering property of the lighting device 1 of Example 3 is superior to that of the comparative lighting device, and in particular, the Ra achieves 90 in the low color temperature range of 4,000 K or less. The difference in the color rendering property between the first color temperature and the second color temperature is larger than those of the other lighting devices 1.

<Lighting device 1, Example 4>

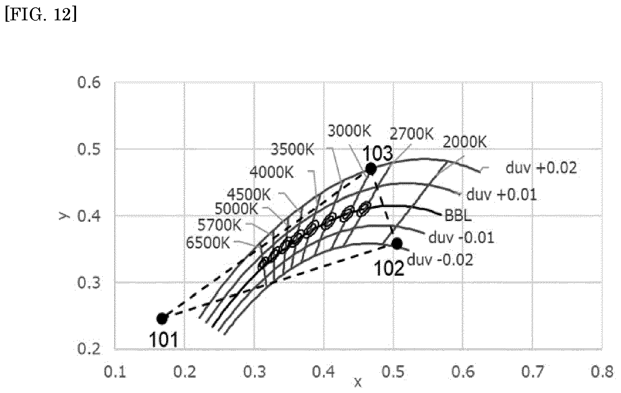

The lighting device 1 of Example 4 is constituted of the first light emitting device 101, the second light emitting device 102, and the third light emitting device 103 of each Example 2. Table 4 shows a result of which the lighting device 1 is evaluated by using the items in the above Table A. The chromaticity diagram of the CIE1931 color system showing a relationship among the first to third chromaticity coordinates, the color temperature changeable range (triangle connecting three points), and the black body radiation locus, in the lighting device 1 of Example 4 is shown in FIG. 12.

[Table 4]

| Target color temperature Tcp [K] | Result color temperature Tcp [K] | Color deviation duv | Melanopic ratio MR | Luminous efficiency [lm/W] | Average color rendering index Ra |
|---|---|---|---|---|---|
| 2700 | 2697 | 0.000 | 0.45 | 185 | 84 |
| 3000 | 3005 | 0.000 | 0.52 | 187 | 86 |
| 3500 | 3513 | 0.000 | 0.63 | 187 | 90 |
| 4000 | 4017 | 0.000 | 0.73 | 185 | 92 |
| 4500 | 4529 | 0.000 | 0.81 | 182 | 94 |
| 5000 | 5042 | 0.000 | 0.89 | 179 | 94 |
| 5700 | 5759 | 0.000 | 0.98 | 174 | 94 |
| 6500 | 6568 | 0.000 | 1.07 | 169 | 94 |

As described above, in the lighting device 1 of Example 4, the MR change amount in the correlated color temperature range of 2,700 K to 6,500 K is larger than that of the comparative lighting device. Also, the MR change amount in the range of 3,000 K to 5,000 K is larger than that of the comparative lighting device. Further, the MR value at each of the same color temperatures is higher than that of the comparative lighting device. The MR value of the lighting device 1 of Example 4 is less than 1.0 when light having a correlated color temperature of 5,000 K on the black body radiation locus (the color deviation duv is 0.000) is emitted. The MR change amount of the lighting device 1 of Example 4 is 0.4 or more when the color temperature of light is changed in a range of correlated color temperatures of 3,000 K to 5,000 K on the black body radiation locus.

The lighting device 1 of Example 4 has characteristics similar to those of the lighting device 1 of Example 2. In the lighting device 1 of Example 4, similarly to the lighting device 1 of Example 2, the **MR** value at a low color temperature (first color temperature) is not much different from that of the comparative lighting device, and the difference is widened at a high color temperature (second color temperature). However, the difference at a high color temperature is smaller than that of the lighting device 1 of Example 2. On the other hand, the color rendering property at a high color temperature of 4,000 K or more is superior to that of the lighting device 1 of Example 2.

<Lighting device 1, Example 5>

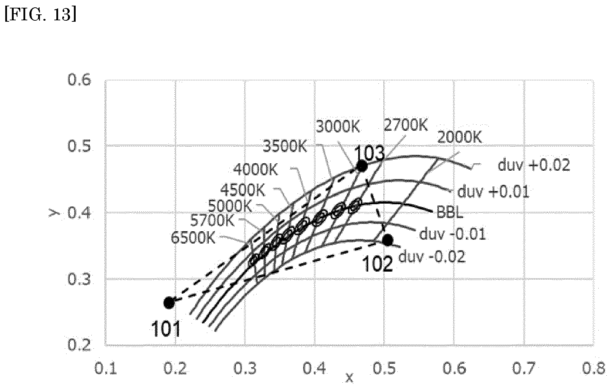

The lighting device 1 of Example 5 is constituted of the first light emitting device 101 of Example 3, and the second light emitting device 102 and the third light emitting device 103 of each Example 2. Table 5 shows a result of which the lighting device 1 is evaluated by using the items in the above Table A. The chromaticity diagram showing a relationship among the first to third chromaticity coordinates, the color temperature changeable range (triangle connecting three points), and the black body radiation locus, in the lighting device 1 of Example 5 is shown in FIG. 13.

[Table 5]

| Target color temperature Tcp [K] | Result color temperature Tcp [K] | Color deviation duv | Melanopic ratio MR | Luminous efficiency [lm/W] | Average color rendering index Ra |
|---|---|---|---|---|---|
| 2700 | 2700 | 0.000 | 0.45 | 185 | 83 |
| 3000 | 3002 | 0.000 | 0.53 | 186 | 86 |
| 3500 | 3506 | 0.000 | 0.65 | 186 | 88 |
| 4000 | 4014 | 0.000 | 0.75 | 184 | 90 |
| 4500 | 4519 | 0.000 | 0.85 | 181 | 92 |
| 5000 | 5031 | 0.000 | 0.93 | 177 | 93 |
| 5700 | 5740 | 0.000 | 1.03 | 172 | 95 |
| 6500 | 6561 | 0.000 | 1.13 | 167 | 94 |

As described above, in the lighting device 1 of Example 5, the MR change amount in the correlated color temperature range of 2,700 K to 6,500 K is larger than that of the comparative lighting device. Also, the MR change amount in the range of 3,000 K to 5,000 K is larger than that of the comparative lighting device. Further, the MR value at each of the same color temperatures is higher than that of the comparative lighting device. The lighting device 1 of Example 5 has characteristics almost similar to those of the lighting device 1 of Example 4. The MR value of the lighting device 1 of Example 5 is less than 1.0 when light having a correlated color temperature of 5,000 K on the black body radiation locus (the color deviation duv is 0.000) is emitted. The MR change amount of the lighting device 1 of Example 5 is 0.4 or more when the color temperature of light is changed in a range of correlated color temperatures of 3,000 K to 5,000 K on the black body radiation locus.

According to the lighting devices 1 described above with reference to Examples, the color temperature can be changed while changing the MR value in a greater range compared to conventional lighting devices. Accordingly, a lighting in consideration of influence on a human body can be provided.

In each of lighting devices 1 of Examples 1 to 5, the color temperature on the black body radiation locus can be changed, and when the color temperature of light is changed in the correlated color temperature range of 3,000 K to 5,000 K, the change amount in the value of the melanopic ratio (MR change amount) reaches at least 0.35. In the preferred lighting device 1, the change amount in the value of the melanopic ratio reaches at least 0.40. In the more preferred lighting device 1, the change amount in the value of the melanopic ratio reaches at least 0.45.

When the color temperature of light is changed in the correlated color temperature range of 2,700 K to 6,500 K, the change amount in the value of the melanopic ratio reaches at least 0.6. In the preferred lighting device 1, the change amount in the value of the melanopic ratio reaches at least 0.70. In the more preferred lighting device 1, the change amount in the value of the melanopic ratio reaches at least 0.75.

In the preferred lighting device 1, the melanopic ratio at a correlated color temperature of 3,000 K is 0.5 or less, and the melanopic ratio at a correlated color temperature of 5,000 K is 1.0 or more. In the lighting device 1 of Example 1 that realizes the largest value of the melanopic ratio, the value of the melanopic ratio at a correlated color temperature of 6,500 K reaches 1.3. That is, the value of a melanopic ratio of the lighting device 1 of Example 1 reaches 1.3 when light having a correlated color temperature of 6,500 K on the black body radiation locus is emitted.

In practice, when used as an lighting device, not only a comparison of the simple melanopic ratio values, but also a relationship with the luminous efficiency can be important. In the case in which the luminous efficiency is low, the luminous flux [lm] can be increased by increasing the input power [W] accordingly. However, if the control such as changing the input power according to the color temperature is performed within the color temperature range, the configuration of the devices becomes complicated. In addition, high satisfaction from user can be obtained by avoiding sacrifice in an energy-saving element as much as possible.

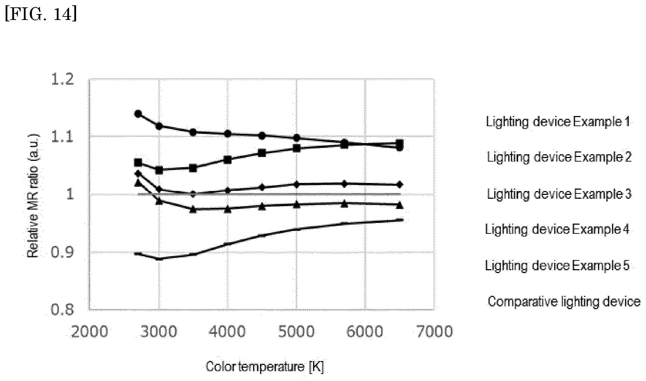

FIG. 14 is a graph comparing the comparative lighting device and the lighting devices 1 of Examples 1 to 5 using a value obtained by multiplying the MR value and the luminous efficiency. The multiplied value represents the relative relationship of the melanopic ratio in the lighting to be illuminated with a power of 1.0 [W]. Hereinafter, the value is referred to as a relative melanopic ratio. In order to facilitate comparison, the comparative lighting device is used as a reference.

As shown in FIG. 14, it is clearly seen that the lighting device 1 of Example 1 and the lighting device 1 of Example 2 have a larger relative melanopic ratio than that of the comparative lighting device. In the lighting device 1 of Example 1, the relative melanopic ratio is high at a low color temperature and decreases as the color temperature becomes higher. In the lighting device 1 of Example 2, the relative melanopic ratio is high at a high color temperature and increases as the color temperature becomes higher.

It can be said that the lighting device having a higher relative melanopic ratio at a high color temperature can provide light in consideration of circadian rhythm while considering energy efficiency. It can be said that the lighting device 1 of Example 2 has good performance as a lighting in consideration of circadian rhythm.

Next, the color temperature control performed using the lighting device 1 will be described.

The lighting device 1 is able to change color temperature using at least three light emitting devices 10, and the color temperature range includes the first temperature to the second temperature on the black body radiation locus. Thus, the color temperature change along the black body radiation locus can be performed with higher accuracy, compared with the comparative lighting device constituted with two light emitting devices.

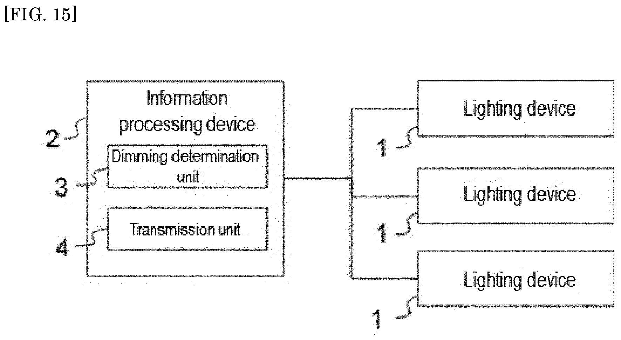

Such control of color temperature change in the correlated color temperature range from the first temperature to the second temperature, can be realized by constituting a color temperature control system including a plurality of the lighting devices 1 and an information processing device 2 that is communicably connected to a controller for each of the lighting devices 1 and which adjusts light emitted from each lighting device 1 by controlling the controller. FIG. 15 is a diagram illustrating an example of constitution of the color temperature control system. The number of the lighting devices 1 can be one.

The information processing device 2 is a computer, a server device, or the like, and is a device capable of transmitting and receiving information via communication interface and executing arithmetic processing based on received information or recorded information. The information processing device 2 includes a processor such as a CPU for controlling arithmetic processing, a storage unit such as an HDD for storing programs and information, and a memory such as a ROM or a RAM that provides a storage area for developing a program and executing processing.

In the color temperature control system, the information processing device 2 includes a color temperature determination unit 3 that determines a control command to the controller in order to control light emitted from the lighting device 1. In the color temperature determination unit 3, when controlling color temperature in the correlated color temperature range from the first temperature to the second temperature, the light emission ratio of the light emitting device 10 is determined such that the light is irradiated with chromaticity coordinates closer to the black body radiation locus than a straight line connecting the first temperature and the second temperature on the black body radiation locus in the chromaticity diagram of the CIE1931 color system.

The information processing device 2 also includes a transmission unit 4 that transmits a control command to the controller. The transmission unit 4 transmits a control command to the controller such that the light emitting device 10 emits light with the determined light emission ratio. Thereby, the controller executes color temperature change based on the control command, and the color temperature change along the black body radiation locus can be performed with high accuracy.

In the chromaticity diagram of the CIE1931 color system, the control range of color temperature change by the information processing device 2 is within an area surrounded by a straight line connecting the first temperature and the second temperature on the black body radiation locus, and a set of points located at twice the distance from points on the straight line to points on the black body radiation locus at the same correlated color temperatures, which is obtained at all the points on the straight line between the first temperature and the second temperature. Also, the control range is within the inside of the outer frame, but not on the outer frame of the area, at least in any correlated color temperature between the first temperature and the second temperature. In the chromaticity diagram of the CIE1931 color system, the control range of color temperature change by the information processing device 2 is preferably within a color deviation duv of $\pm0.001$ from the black body radiation locus between the first temperature and the second temperature.

In order to perform color temperature change in accordance with the circadian rhythm, the color temperature change is preferably performed corresponding to the change in the color temperature of sunlight. However, the color temperature change may not be accurately performed according to the change of sunlight. For example, the following color temperature change can be considered. In a day, the MR value is set to the minimum value of the day at 0:00 to 6:00, and changes to the maximum value at 6:00. Then, the MR value is maintained at the maximum value until 15:30, decreases with time from 15:30 to 19:00, and set to the minimum value after 19:00.

That is, the information processing device 2 controls the MR value so as to be the maximum at a predetermined time in the morning. Then, the information processing device 2 controls to decrease the MR value over a certain time from a predetermined time in the afternoon. Here, the MR value can be increased over a certain time from a predetermined time in the morning.

The MR value becomes maximum when the color temperature is maximized in the color temperature range. On the other hand, the MR value becomes minimum when the color temperature is minimized in the color temperature range.

Although the embodiments according to the present disclosure have been described above, the technical idea of the present disclosure is not limited to the specific embodiments described. For example, in the embodiments, the installation place of the color temperature control system according to the present disclosure is not necessarily limited to an office building.

The first light emitting device 101, the second light emitting device 102, and the third light emitting device 103 can be mounted on the substrate 30 as physically individual light emitting devices 10, or can be mounted by integrally forming a plurality of light emitting devices by appropriately determined number.

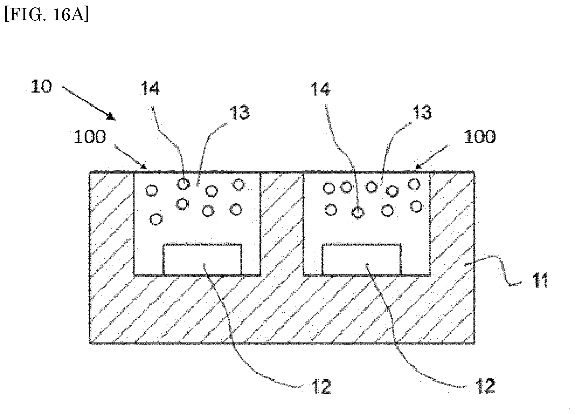

FIGS. 16A to 16C each show an exemplary light emitting device 10 in which a plurality of light emitting devices 100 are integrally formed. The plurality of light emitting devices 100 integrally formed includes two or more light emitting devices selected from the first light emitting device 101, the second light emitting device 102, and the third light emitting device 103.

FIG. 16A shows a structure of the light emitting device 10 in which two cavities are formed in one molded body 11, and among the plurality of light emitting devices 100, a light emitting element 12 and a wavelength conversion member 13 of one light emitting device 100, and a light emitting element 12 and a wavelength conversion member 13 of another light emitting device 100 are respectively disposed in the cavities.

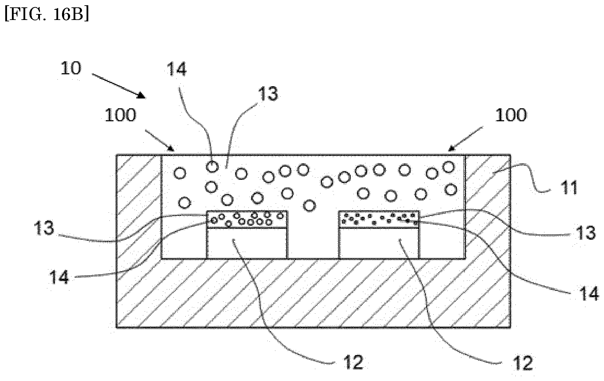

FIG. 16B shows a structure of the light emitting device 10 in which one cavity is formed in one molded body 11, and among the plurality of light emitting devices 100, a light emitting element 12 and a wavelength conversion member 13 of one light emitting device 100, and a light emitting element 12 and a wavelength conversion member 13 of another light emitting device 100 are disposed in the cavity.

A wavelength conversion member 13 that contributes to light emission by one light emitting device 100 (one of the two light emitting devices 100 shown in the figure) and is not necessary for light emission by another light emitting device 100 (another one of the two light emitting devices 100 shown in the figure), is provided only around the light emitting element 12 of the one light emitting device 100. Similarly, a wavelength conversion member 13 that contributes to light emission by the other light emitting device 100 and is not necessary for light emission by the one light emitting device 100, is provided only around the light emitting element 12 of the other light emitting device 100. The wavelength conversion member 13 needed for light emission by the one light emitting device 100 and the other light emitting device 100 is provided so as to cover both the light emitting devices 100.

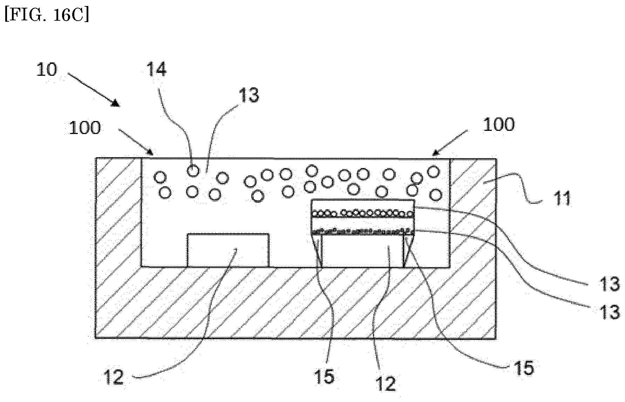

FIG. 16C shows a structure of the light emitting device 10 in which one cavity is formed in one molded body 11, and a light emitting element 12 and a wavelength conversion member 13 of one light emitting device 100, and a light emitting element 12 and one or more wavelength conversion members 13 of another light emitting device 100 are disposed in the cavity.

In comparison with FIG. 16B, a wavelength conversion member 13 that contributes to light emission by the one light emitting device 100 but is not necessary for light emission by the other light emitting device 100, is not provided in the one light emitting device 100. On the other hand, a wavelength conversion member 13 that contributes to light emission by the other light emitting device 100 but is not necessary for light emission by the one light emitting device 100, is provided only around the light emitting element 12 of the other light emitting device 100.

The wavelength conversion member 13 provided only around the light emitting element 12 of the other light emitting device 100 can be configured as a single layer or a plurality of layers. In each layer, fluorescent materials can be locally distributed on the lower surface. For example, such a wavelength conversion member 13 can be formed by attaching a sheet-shaped fluorescent material to a glass material.

One or more lateral surfaces of the light emitting element 12 of the other light emitting device 100 are covered with reflective layers 15. Thereby, the light emitted from the light emitting element 12 of the one light emitting device 100 is reflected by the reflective layers 15 before entering into the light emitting element 12 of the other light emitting device 100. Thus, the light emitted from the light emitting element 12 of the one light emitting device 100 is less likely to be subject to wavelength conversion by the wavelength conversion member 13 provided only around the light emitting element 12 of the other light emitting device 100.

As described above, the light emitting device 10 is configured as a plurality of light emitting devices 100 in which the first light emitting device 101, the second light emitting device 102, and the third light emitting device 103 are integrally formed. With such a configuration, the light emitting device 10 can be handled as one integrated package. Further, by controlling the light emitted from the light emitting device 10 as described above, the color temperature control system can be realized.

The present invention can be applied without necessarily and sufficiently providing all the constituent elements disclosed by the embodiments. **The** scope of the present invention is defined by the claims.

Industrial Applicability

The color temperature control system and the lighting device described in the embodiments can be used in the field of lighting installed in an indoor space or the like.

Reference Signs List

1 lighting device
10 light emitting device
101 first light emitting device
102 second light emitting device
103 third light emitting device
11 molded body
12 light emitting element
13 wavelength conversion member
14 fluorescent material
15 reflective layer
20 base plate
30 substrate
40 cover
50 installation member
2 information processing device
3 color temperature determination unit
4 transmission unit

**Claims**

1. A lighting device (1), configured to control a color temperature in a range of correlated color temperatures from a first temperature to a second temperature that is higher than the first temperature by 2,000 K or more, the lighting device (1) comprising:

   - a first light emitting device (101) that emits light having a light emission color of first chromaticity coordinates in which values of x and y in the first chromaticity coordinates are equal to or less than values of x and y at the second temperature on the black body radiation locus, respectively, in a chromaticity diagram of the CIE1931 color system;
   - a second light emitting device (102) that emits light having a light emission color of second chromaticity coordinates in which a value of x in the second chromaticity coordinates is equal to or more than a value of x at the first temperature on the black body radiation locus, in the chromaticity diagram of the CIE1931 color system; and
   - a third light emitting device (103) that emits light having a light emission color of third chromaticity coordinates in which a value of x in the third chromaticity coordinates is a first value, and, when a straight line passing through the first temperature and the second temperature on the black body radiation locus is represented by a function of x and y, a value of y in the third chromaticity coordinates is a second value larger than a value of y obtained by substituting the first value for the value of x in the function, in the chromaticity diagram of the CIE1931 color system, wherein

- light in a range from the first temperature to the second temperature on the black body radiation locus is included in a triangular area surrounded by a straight line connecting the first chromaticity coordinates and the second chromaticity coordinates, a straight line connecting the second chromaticity coordinates and the third chromaticity coordinates, and a straight line connecting the third chromaticity coordinates and the first chromaticity coordinates, in the chromaticity diagram of the CIE1931 color system;
- the first light emitting device (101), the second light emitting device (102). and the third light emitting device (103) are used to control the color temperature of the light in the range from the first temperature to the second temperature;
- a value of a melanopic ratio is 1.0 or more when light having a correlated color temperature of 5,000 K on the black body radiation locus is emitted;
- a change amount of a value of the melanopic ratio is 0.4 or more when a color temperature of light is changed in a range of correlated color temperatures of 3,000 K to 5,000 K on the black body radiation locus;
- in the first chromaticity coordinates, the value of x is in a range of 0.1 or more and 0.2 or less, and the value of y is in a range of 0.2 or more and 0.3 or less, in the chromaticity diagram of the CIE1931 color system;
- the first light emitting device (101) has a value of the melanopic ratio of 2.0 or more;
- in the second chromaticity coordinates, the value of y is less than the value of y at the first temperature on the black body radiation locus, and the value of x is in a range of 0.45 or more and 0.6 or less, in the chromaticity diagram of the CIE1931 color system;
- the second light emitting device (102) has a value of the melanopic ratio of smaller than 0.40;
- in the third chromaticity coordinates, the value of x is in a range of 0.4 or more and 0.5 or less, in the chromaticity diagram of the CIE1931 color system; and
- the third light emitting device (103) has a value of the melanopic ratio of 0.5 or less.

2. The lighting device (1) according to claim 1, wherein the value of x in the first chromaticity coordinates is smaller than the value of x at the second temperature on the black body radiation locus by 0.1 or more.

3. The lighting device (1) according to claim 1 or 2, wherein, when the color temperature of light is changed in a range of correlated color temperatures of 3,000 to 5,000 K on the black body radiation locus, an average color rendering index is in a range of 85 or more and 94 or less, and a luminous efficiency is in a range of 170 lm/W or more and 182 lm/W or less.

4. The lighting device (1) according to any one of claims 1 to 3, wherein the first light emitting device (101), the second light emitting device (102), and the third light emitting device (103) each include a light emitting element (12) and a fluorescent material (14).

5. The lighting device (1) according to any one of claims 1 to 4, wherein the first light emitting device (101) includes an alkaline earth metal aluminate fluorescent material (14) having a composition represented by $Sr_4Al_{14}O_{25}$:Eu as a main fluorescent material (14).

6. A color temperature control system, including one or more of the lighting devices (1) according to any one of claims 1 to 5, and an information processing device (2) that is communicably connected to a controller associated with the one or more of the lighting devices (1) and configured to adjust light in a range of correlated color temperatures from a first temperature to a second temperature by the one or more of the lighting devices (1), the information processing device (2) comprising:

- a color temperature determination unit (3) that determines a control command to the controller for controlling the controller to adjust light emitted from the one or more of the lighting devices (1); and
- a transmission unit that transmits the control command determined by the color temperature determination unit (3) to the controller, wherein
- the control range of color temperature change performed by the information processing device (2) is in an area surrounded by a straight line connecting the first temperature and the second temperature on the black body radiation locus, and a set of points located at twice the distance from points on the straight line to points on the black body radiation locus at the same correlated color temperatures, which is obtained at all the points on the straight line between the first temperature and the second temperature, and is in the inside of an outer frame, but not on the outer frame of the area, at least in any correlated color temperature between the first temperature and the second temperature, in the chromaticity diagram of the CIE1931 color system.

7. A color temperature control system, including one or more of the lighting devices (1) according to any one of claims 1 to 5, and an information processing device (2) that is communicably connected to a controller associated with the one or more of the lighting devices (1) and configured to adjust light in a range of correlated color temperatures from a first temperature to a second temperature by the one or more of the lighting devices (1), the information processing device (2) comprising:

- a color temperature determination unit (3) that determines a control command to the controller for controlling the controller to adjust light emitted from the one or more of the lighting devices (1); and
- a transmission unit that transmits the control command determined by the color temperature determination unit (3) to the controller, wherein
- the control range of color temperature change performed by the information processing device (2) between the first temperature and the second temperature is in a color deviation of $\pm 0.001$, in the chromaticity diagram of the CIE1931 color system.

**Patentansprüche**

1. Beleuchtungsvorrichtung (1), die dazu ausgebildet ist, eine Farbtemperatur in einem Bereich von korrelierten Farbtemperaturen von einer ersten Temperatur zu einer zweiten Temperatur zu steuern, die um 2000 K oder mehr höher als die erste Temperatur ist, wobei die Beleuchtungsvorrichtung (1) Folgendes umfasst:

- eine erste lichtemittierende Vorrichtung (101), die Licht emittiert, das eine Lichtemissionsfarbe von ersten Farbartkoordinaten aufweist, bei denen Werte von x und y in den ersten Farbartkoordinaten jeweils gleich groß wie oder kleiner als Werte von x und y bei der zweiten Temperatur auf dem Strahlungsort des schwarzen Körpers in einem Farbartenschaubild des CIE1931-Farbsystems sind;
- eine zweite lichtemittierende Vorrichtung (102), die Licht emittiert, das eine Lichtemissionsfarbe von zweiten Farbartkoordinaten aufweist, bei denen ein Wert von x in den zweiten Farbartkoordinaten gleich groß wie oder größer als ein Wert von x bei der ersten Temperatur auf dem Strahlungsort des schwarzen Körpers im Farbartenschaubild des CIE1931-Farbsystems ist; und
- eine dritte lichtemittierende Vorrichtung (103), die Licht emittiert, das eine Lichtemissionsfarbe von dritten Farbartkoordinaten aufweist, bei denen ein Wert von x in den dritten Farbartkoordinaten ein erster Wert ist, und, wenn im Farbartenschaubild des CIE1931-Farbsystems eine gerade Linie, die durch die erste Temperatur und die zweite Temperatur auf dem Strahlungsort des schwarzen Körpers verläuft, durch eine Funktion von x und y dargestellt wird, ein Wert von y in den dritten Farbartkoordinaten ein zweiter Wert ist, der größer ist als ein Wert von y, der durch Ersetzen des Wertes von x in der Funktion durch den ersten Wert erhalten wird, wobei
- Licht in einem Bereich von der ersten Temperatur bis zur zweiten Temperatur auf dem Strahlungsort des schwarzen Körpers in einem dreieckigen Bereich enthalten ist, der im Farbartenschaubild des CIE1931-Farbsystems von einer geraden Linie, die die ersten Chromatizitätskoordinaten und die zweiten Chromatizitätskoordinaten verbindet, einer geraden Linie, die die zweiten Chromatizitätskoordinaten und die dritten Chromatizitätskoordinaten verbindet, und einer geraden Linie umschlossen wird, die die dritten Chromatizitätskoordinaten und die ersten Chromatizitätskoordinaten verbindet;
- wobei die erste lichtemittierende Vorrichtung (101), die zweite lichtemittierende Vorrichtung (102) und die dritte lichtemittierende Vorrichtung (103) genutzt werden, um die Farbtemperatur des Lichts im Bereich von der ersten Temperatur bis zur zweiten Temperatur zu steuern;
- ein Wert eines melanopischen Verhältnisses 1,0 oder mehr beträgt, wenn Licht emittiert wird, das eine korrelierte Farbtemperatur von 5.000 K auf dem Strahlungsort des schwarzen Körpers aufweist;
- eine Änderungsgröße eines Wertes des melanopischen Verhältnisses 0,4 oder mehr beträgt, wenn eine Farbtemperatur von Licht in einem Bereich von korrelierten Farbtemperaturen von 3000 K bis 5000 K auf dem Strahlungsort des schwarzen Körpers geändert wird;
- in den ersten Farbartkoordinaten der Wert von x in einem Bereich von 0,1 oder mehr und 0,2 oder weniger und der Wert von y in einem Bereich von 0,2 oder mehr und 0,3 oder weniger im Farbartenschaubild des CIE1931-Farbsystems liegt;
- die erste lichtemittierende Vorrichtung (101) einen Wert des melanopischen Verhältnisses von 2,0 oder mehr aufweist;
- in den zweiten Farbartkoordinaten der Wert von y kleiner als der Wert von y bei der ersten Temperatur auf dem Strahlungsort des schwarzen Körpers ist, und der Wert von x im Farbartenschaubild des CIE1931-Farbsystems in einem Bereich von 0,45 oder mehr und 0,6 oder weniger liegt;
- die zweite lichtemittierende Vorrichtung (102) einen Wert des melanopischen Verhältnisses von weniger als 0,40 aufweist;
- in den dritten Farbartkoordinaten der Wert von x im Farbartenschaubild des CIE1931-Farbsystems in einem Bereich von 0,4 oder mehr und 0,5 oder weniger liegt; und
- die dritte lichtemittierende Vorrichtung (103) einen Wert des melanopischen Verhältnisses von 0,5 oder weniger aufweist.

2. Beleuchtungsvorrichtung (1) nach Anspruch 1, wobei der Wert von x in den ersten Farbartkoordinaten auf dem Strahlungsort des schwarzen Körpers um 0,1 oder mehr kleiner ist als der Wert von x bei der zweiten Temperatur.

3. Beleuchtungsvorrichtung (1) nach Anspruch 1 oder 2, wobei, wenn die Farbtemperatur des Lichts in einem Bereich von korrelierten Farbtemperaturen von 3.000 bis 5.000 K auf dem Strahlungsort des schwarzen Körpers geändert wird, ein durchschnittlicher Farbwiedergabeindex in einem Bereich von 85 oder mehr und 94 oder weniger liegt und eine Lichtausbeute in einem Bereich von 170 lm/W oder mehr und 182 lm/W oder weniger liegt.

4. Beleuchtungsvorrichtung (1) nach einem der Ansprüche 1 bis 3, wobei die erste lichtemittierende Vorrichtung (101), die zweite lichtemittierende Vorrichtung (102) und die dritte lichtemittierende Vorrichtung (103) jeweils ein lichtemittierendes Element (12) und ein fluoreszierendes Material (14) umfassen.

5. Beleuchtungsvorrichtung (1) nach einem der Ansprüche 1 bis 4, wobei die erste lichtemittierende Vorrichtung (101) ein Erdalkalimetallaluminat-Fluoreszenzmaterial (14) mit einer durch $Sr_4Al_{14}O_{25}$:Eu dargestellten Zusammenset-zung als Hauptfluoreszenzmaterial (14) umfasst.

6. Farbtemperatur-Steuersystem, umfassend eine oder mehrere der Beleuchtungsvorrichtungen (1) nach einem der Ansprüche 1 bis 5 und eine Informationsverarbeitungsvorrichtung (2), die kommunikativ mit einer Steuerung verbunden ist, die mit der einen oder den mehreren Beleuchtungsvorrichtungen (1) verbunden ist, und dazu ausgebildet ist, Licht in einem Bereich von korrelierten Farbtemperaturen von einer ersten Temperatur zu einer zweiten Temperatur durch die eine oder die mehreren Beleuchtungsvorrichtungen (1) einzustellen, wobei die Informationsverarbeitungsvorrichtung (2) Folgendes umfasst:

   eine Farbtemperaturbestimmungseinheit (3), die einen Steuerbefehl an die Steuerung bestimmt, um die Steuerung so zu steuern, dass sie das von der einen oder den mehreren Beleuchtungsvorrichtungen (1) emittierte Licht anpasst; und
   eine Übertragungseinheit, die den von der Farbtemperaturbestimmungseinheit (3) bestimmten Steuerbefehl an die Steuerung überträgt, wobei
   der Steuerbereich der Farbtemperaturänderung, die durch die Informationsverarbeitungseinrichtung (2) durchgeführt wird, in einem Bereich liegt, der durch eine gerade Linie, die die erste Temperatur und die zweite Temperatur auf dem Strahlungsort des schwarzen Körpers verbindet, und eine Gruppe von Punkten, die sich im Farbartenschaubild des CIE1931-Farbsystems zumindest in jeder korrelierten Farbtemperatur zwischen der ersten Temperatur und der zweiten Temperatur in der doppelten Entfernung von Punkten auf der geraden Linie zu Punkten auf dem Strahlungsort des schwarzen Körpers bei denselben korrelierten Farbtemperaturen befinden, die an allen Punkten auf der Geraden zwischen der ersten Temperatur und der zweiten Temperatur erhalten wird und sich innerhalb eines äußeren Rahmens, jedoch nicht auf dem äußeren Rahmen des Bereichs befindet.

7. Ein Farbtemperatur-Steuersystem, umfassend eine oder mehrere der Beleuchtungseinrichtungen (1) nach einem der Ansprüche 1 bis 5 und eine Informationsverarbeitungsvorrichtung (2), die kommunikativ mit einer Steuerung verbunden ist, die mit der einen oder den mehreren Beleuchtungseinrichtungen (1) verbunden ist, und dazu ausgebildet ist, Licht in einem Bereich von korrelierten Farbtemperaturen von einer ersten Temperatur zu einer zweiten Temperatur durch die eine oder die mehreren der Beleuchtungseinrichtungen (1) anzupassen, wobei die Informationsverarbeitungsvorrichtung (2) Folgendes umfasst:

   eine Farbtemperaturbestimmungseinheit (3), die einen Steuerbefehl an die Steuerung bestimmt, um die Steuerung so zu steuern, dass sie das von der einen oder den mehreren Beleuchtungsvorrichtungen (1) emittierte Licht anpasst; und
   eine Übertragungseinheit, die den von der Farbtemperaturbestimmungseinheit (3) bestimmten Steuerbefehl an die Steuerung überträgt, wobei
   der Steuerbereich der Farbtemperaturänderung, die von der Informationsverarbeitungseinrichtung (2) zwischen der ersten Temperatur und der zweiten Temperatur durchgeführt wird, in einer Farbabweichung von $\pm 0{,}001$ im Farbartenschaubild des CIE1931-Farbsystems liegt.

**EP 4 054 294 B1**

## Revendications

1. Dispositif d'éclairage (1), configuré pour commander une température de couleur dans une plage de températures de couleur corrélées d'une première température à une seconde température qui est supérieure à la première température de 2 000 K ou plus, le dispositif d'éclairage (1) comprenant :

   - un premier dispositif électroluminescent (101) qui émet de la lumière présentant une couleur d'émission de lumière de premières coordonnées de chromaticité dans lesquelles des valeurs de x et y dans les premières coordonnées de chromaticité sont égales ou inférieures à des valeurs de x et y à la seconde température sur le lieu de rayonnement de corps noir, respectivement, dans un diagramme de chromaticité du système de couleurs CIE1931 ;
   - un deuxième dispositif électroluminescent (102) qui émet de la lumière présentant une couleur d'émission de lumière de deuxièmes coordonnées de chromaticité dans lesquelles une valeur de x dans les deuxièmes coordonnées de chromaticité est égale ou supérieure à une valeur de x à la première température sur le lieu de rayonnement de corps noir, dans le diagramme de chromaticité du système de couleurs CIE1931 ; et
   - un troisième dispositif électroluminescent (103) qui émet de la lumière présentant une couleur d'émission de lumière de troisièmes coordonnées de chromaticité dans lesquelles une valeur de x dans les troisièmes coordonnées de chromaticité est une première valeur, et, lorsqu'une ligne droite passant par la première température et la seconde température sur le lieu de rayonnement de corps noir est représentée par une fonction de x et y, une valeur de y dans les troisièmes coordonnées de chromaticité est une seconde valeur supérieure à une valeur de y obtenue en substituant la première valeur à la valeur de x dans la fonction, dans le diagramme de chromaticité du système de couleurs CIE1931, dans lequel
   - la lumière dans une plage allant de la première température à la seconde température sur le lieu de rayonnement de corps noir est incluse dans une zone triangulaire entourée par une ligne droite reliant les premières coordonnées de chromaticité et les deuxièmes coordonnées de chromaticité, une ligne droite reliant les deuxièmes coordonnées de chromaticité et les troisièmes coordonnées de chromaticité, et une ligne droite reliant les troisièmes coordonnées de chromaticité et les premières coordonnées de chromaticité, dans le diagramme de chromaticité du système de couleurs CIE1931 ;
   - le premier dispositif électroluminescent (101), le deuxième dispositif électroluminescent (102) et le troisième dispositif électroluminescent (103) sont utilisés pour réguler la température de couleur de la lumière dans la plage allant de la première température à la seconde température ;
   - une valeur d'un rapport mélanopique est 1,0 ou plus lorsque de la lumière présentant une température de couleur corrélée de 5 000 K sur le lieu de rayonnement de corps noir est émise ;
   - une quantité de changement d'une valeur du rapport mélanopique est 0,4 ou plus lorsqu'une température de couleur de la lumière est modifiée dans une plage de températures de couleur corrélées de 3 000 K à 5 000 K sur le lieu de rayonnement de corps noir ;
   - dans les premières coordonnées de chromaticité, la valeur de x est dans une plage de 0,1 ou plus et de 0,2 ou moins, et la valeur de y est dans une plage de 0,2 ou plus et de 0,3 ou moins, dans le diagramme de chromaticité du système de couleurs CIE1931 ;
   - le premier dispositif électroluminescent (101) présente une valeur du rapport mélanopique de 2,0 ou plus ;
   - dans les deuxièmes coordonnées de chromaticité, la valeur de y est inférieure à la valeur de y à la première température sur le lieu de rayonnement de corps noir et la valeur de x est dans une plage de 0,45 ou plus et de 0,6 ou moins, dans le diagramme de chromaticité du système de couleurs CIE1931 ;
   - le deuxième dispositif électroluminescent (102) présente une valeur du rapport mélanopique inférieure à 0,40 ;
   - dans les troisièmes coordonnées de chromaticité, la valeur de x est dans une plage de 0,4 ou plus et de 0,5 ou moins, dans le diagramme de chromaticité du système de couleurs CIE1931 ; et
   - le troisième dispositif électroluminescent (103) présente une valeur du rapport mélanopique de 0,5 ou moins.

2. Dispositif d'éclairage (1) selon la revendication 1, dans lequel la valeur de x dans les premières coordonnées de chromaticité est inférieure à la valeur de x à la seconde température sur le lieu de rayonnement de corps noir de 0,1 ou plus.

3. Dispositif d'éclairage (1) selon la revendication 1 ou 2, dans lequel, lorsque la température de couleur de la lumière est modifiée dans une plage de températures de couleur corrélées de 3 000 à 5 000 K sur le lieu de rayonnement de corps noir, un indice de rendu des couleurs moyen est dans une plage de 85 ou plus et de 94 ou moins, et une efficacité lumineuse est dans une plage de 170 lm/W ou plus et de 182 lm/W ou moins.

4. Dispositif d'éclairage (1) selon l'une quelconque des revendications 1 à 3, dans lequel le premier dispositif électroluminescent (101), le deuxième dispositif électroluminescent (102) et le troisième dispositif électroluminescent (103) incluent chacun un élément électroluminescent (12) et un matériau fluorescent (14).

5. Dispositif d'éclairage (1) selon l'une quelconque des revendications 1 à 4, dans lequel le premier dispositif électroluminescent (101) inclut un matériau fluorescent d'aluminate de métal alcalino-terreux (14) présentant une composition représentée par $Sr_4Al_{14}O_{25}$ en tant que matériau fluorescent principal (14).

6. Système de régulation de température de couleur, incluant un ou plusieurs des dispositifs d'éclairage (1) selon l'une quelconque des revendications 1 à 5, et un dispositif de traitement d'informations (2) qui est relié en communication à un dispositif de commande associé aux un ou plusieurs des dispositifs d'éclairage (1) et configuré pour ajuster la lumière dans une plage de températures de couleur corrélées d'une première température à une seconde température par les un ou plusieurs des dispositifs d'éclairage (1), le dispositif de traitement d'informations (2) comprenant :

  - une unité de détermination de température de couleur (3) qui détermine une instruction de commande au dispositif de commande pour commander le dispositif de commande pour ajuster la lumière émise par les un ou plusieurs des dispositifs d'éclairage (1) ; et
  - une unité de transmission qui transmet l'instruction de commande déterminée par l'unité de détermination de température de couleur (3) au dispositif de commande, dans lequel
  - la plage de commande du changement de température de couleur effectuée par le dispositif de traitement d'informations (2) est dans une zone entourée par une ligne droite reliant la première température et la seconde température sur le lieu de rayonnement de corps noir, et un ensemble de points situés à deux fois la distance de points sur la ligne droite à des points sur le lieu de rayonnement de corps noir aux mêmes températures de couleur corrélées, qui est obtenue à tous les points sur la ligne droite entre la première température et la seconde température, et se trouve à l'intérieur d'un cadre externe, mais pas sur le cadre externe de la zone, au moins dans n'importe quelle température de couleur corrélée entre la première température et la seconde température, dans le diagramme de chromaticité du système de couleurs CIE1931.

7. Système de régulation de température de couleur, incluant un ou plusieurs des dispositifs d'éclairage (1) selon l'une quelconque des revendications 1 à 5, et un dispositif de traitement d'informations (2) qui est relié en communication à un dispositif de commande associé aux un ou plusieurs des dispositifs d'éclairage (1) et configuré pour ajuster la lumière dans une plage de températures de couleur corrélées d'une première température à une seconde température par les un ou plusieurs des dispositifs d'éclairage (1), le dispositif de traitement d'informations (2) comprenant :

  - une unité de détermination de température de couleur (3) qui détermine une instruction de commande au dispositif de commande pour commander le dispositif de commande pour ajuster la lumière émise par les un ou plusieurs des dispositifs d'éclairage (1) ; et
  - une unité de transmission qui transmet l'instruction de commande déterminée par l'unité de détermination de température de couleur (3) au dispositif de commande, dans lequel
  - la plage de commande du changement de température de couleur effectuée par le dispositif de traitement d'informations (2) entre la première température et la seconde température est dans un écart de couleur de ± 0,001, dans le diagramme de chromaticité du système de couleurs CIE1931.

[FIG. 1]

[FIG. 2]

[FIG. 3]

[FIG. 4]

[FIG. 5]

[FIG. 6]

[FIG. 7]

[FIG. 8]

Third light emitting device

[FIG. 9]

[FIG. 10]

[FIG. 11]

[FIG. 12]

[FIG. 13]

[FIG. 14]

[FIG. 15]

[FIG. 16A]

[FIG. 16B]

[FIG. 16C]

**REFERENCES CITED IN THE DESCRIPTION**

**Patent documents cited in the description**

- JP 2018 A
- JP 129492 A
- WO 2019140306 A1
- WO 2019139636 A1
- US 20180368218 A1
- WO 2016146688 A1